# EUROPEAN PATENT SPECIFICATION

(11) **EP 1 554 787 B1**
(45) Date of publication and mention of the grant of the patent: **10.01.2007**
(21) Application number: 02779348.8
(22) Date of filing: 13.09.2002
(51) Int. Cl.: H01S 5/14, H01S 5/0687

(54) **CONTROL OF LASER TUNING VELOCITY**
STEUERUNG DER LASERABSTIMMGESCHWINDIGKEIT
COMMANDE DE VITESSE D'ACCORD DE LASER

(43) Date of publication of application: 20.07.2005
(73) Proprietor: Agilent Technologies Inc, Palo Alto, CA 94306-2024 (US)
(72) Inventor: STEFFENS, Wolf, 71083 Herrenberg (DE); KALLMANN, Ulrich, 72076 Tuebingen (DE); HAEUSSLER, Ralf, 01309 Dresden (DE); NEBENDAHL, Bernd, 71254 Ditzingen (DE); JENSEN, Thomas, 9400 Rohrschach (DE); MUELLER, Emmerich, 71134 Aidlingen (DE)
(74) Representative: Neuerburg, Gerhard
(86) International application number: PCT/EP2002/010286
(87) International publication number: WO 2004/025794

(56) References cited:
- EP-A- 0 479 118
- EP-A- 1 220 389
- WO-A-00/49689
- DE-A- 4 429 748
- US-B1- 6 426 496

## Description

### BACKGROUND OF THE INVENTION

The present invention relates to manipulating a laser source, in particular to manipulating an optical signal leaving the laser source, more particular to manipulating an optical signal leaving a tunable laser source (TLS) swept in frequency.

DE 44 29 748 A1 discloses a method and an apparatus of stabilizing the wavelength of a laser source, comprising an interferometer and a measurement circuit for determining a wavelength of the output signal of the laser source. In an embodiment, a signal for stabilizing the determined wavelength is derived from the determined wavelength and fed back to the laser source.

### SUMMARY OF THE INVENTION

It is an object of the invention to provide improved manipulation of a laser source. The object is solved by the independent claims.

When tuning or sweeping the frequency of a TLS it often happens that the tuning velocity of the TLS is not linear. An advantage of an embodiment of the present invention is the possibility of compensating such non-linearity in the sweeping velocity when sweeping the frequency of the TLS.

Another advantage of embodiments of the present invention is that it is possible to compensate jitter on a signal of a certain frequency of the TLS, i.e. small but fast oscillations of the signal of the TLS about the desired frequency. Since jitter can also be understood as a tuning velocity, although undesired, jitter can be compensated, also. This can be done for example by interferometrically analyzing the signal generated by the TLS. If any beat frequency, i.e. a frequency generated by an interferometer in which light is split and recombined again after propagating two different path length, can be detected in the superimposed signal of the interferometer then there is jitter, i.e. a small and fast but undesired tuning velocity, on the signal which can be compensated until there is no jitter on the signal any more, i.e. the tuning velocity is zero.

In an embodiment of the present invention the compensation is realized by measuring an actual value of an indicator of the sweeping velocity, preferably by using a frequency or wavelength reference unit (WRU), by comparing the measured value with a desired value, preferably by using a deviation detector, and by compensating a deviation when a deviation was detected, preferably by using a phase controller influencing the signal of the laser source. The indicator can also be the tuning velocity itself. The WRU can be embodied by any kind of appropriate wavemeter and preferably as disclosed in any one of the following patent applications: EP-A-1099943, EP-A-1221599, or EP-A-0875743.

Furthermore, it is advantageous to generate the desired value by an electrical signal generator which can be forced by an appropriate control unit to generate as an indicator of the desired tuning velocity a frequency corresponding to the desired tuning velocity. Advantageously, this frequency can then be compared with a frequency measured by an interferometric WRU and a possible detection of a deviation is then be used to influence the optical signal created by the TLS.

The TLS can be influenced by using a phase controller introduced into the path of the laser in the TLS. Preferably, the phase controller comprises a fast phase controller to react on fast but small deviations and a slow phase controller to react on slow but large deviations. The fast phase controller can comprise an electro-optical modulator (EOM). The slow phase controller can comprise an actuator, which can comprise a piezo-electric element.

Possible application fields of embodiments of the present invention are measurement setups for measuring an optical property of a device under test using a TLS.

Other preferred embodiments are shown by the dependent claims.

It is clear that the invention can be partly embodied or supported by one or more suitable software programs, which can be stored on or otherwise provided by any kind of data carrier, and which might be executed in or by any suitable data processing unit.

### BRIEF DESCRIPTION OF THE DRAWINGS

Other objects and many of the attendant advantages of the present invention will be readily appreciated and become better understood by reference to the following detailed description when considering in connection with the accompanied drawings. The components in the drawings are not necessarily to scale, emphasis instead being placed upon clearly illustrating the principles of the present invention. Features that are substantially or functionally equal or similar will be referred to with the same reference sign(s).

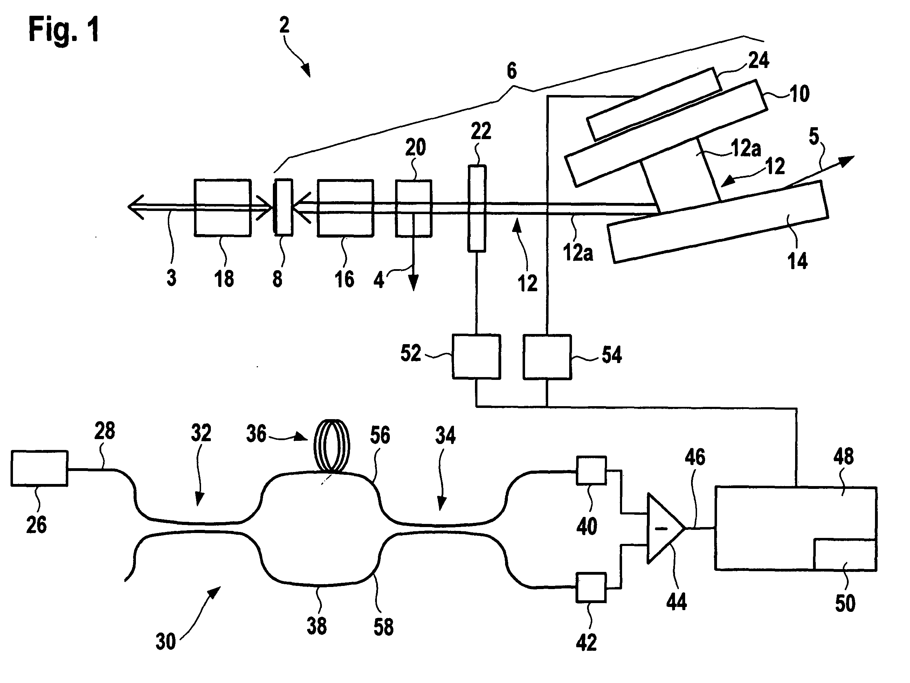

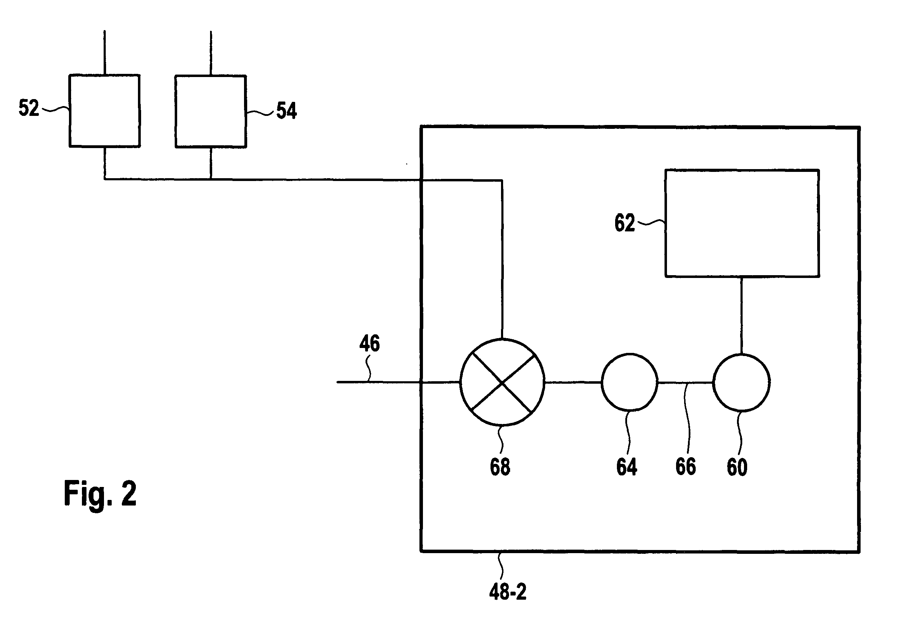

- Fig. 1 and 2: show schematic illustrations of embodiments of the present invention.

### DETAILED DESCRIPTION PREFERRED EMBODIMENTS OF THE INVENTION

Referring now in greater detail to the drawings, Fig. 1 shows a schematic illustration of an apparatus for compensating a deviation of an optical signal compared to a desired value, e.g. for compensating a non-linearity in a sweeping velocity of a TLS 2, according to an embodiment of the present invention.

In the specific embodiment of the TLS 2 as shown herein, the TLS 2 provides as output at least one of laser beams 3, 4, 5 and comprises a laser cavity 6. The laser cavity 6 comprises a lasing chip 8 and a cavity end element 10 providing a path 12 for the laser beam 12a within the cavity 6. In the path 12 there is introduced a movable tuning element 14 to tune the TLS 2. In this embodiment the TLS 2 is tuned with a tuning velocity of e.g. 100GHz/s. A lens 16 in the path 12 adjacent to the chip 8 is provided to focus the laser beam 12a onto the chip 8. A lens 18 adjacent to the chip 8 opposite to the lens 16 is provided to focus the resulting laser beam 3 of the TLS 2. A beam splitter 20 in the path 12 adjacent to the lens 16 is provided to provide the resulting laser beam 4 of the TLS 2.

Any other type of TLS as the specific embodiment of TLS 2 can be applied accordingly, as will be shown in the following.

An EOM 22 as a fast phase controller (FPC) in the path 12 adjacent to the beam splitter 20 is provided as a fast phase control of the resulting beams 3, 4, 5 of the TLS 2. A piezo electric element 24 as a slow phase controller (SPC) in contact with the cavity end element 10 provides a slow phase control of the resulting beams 3, 4, 5 of the TLS 2. How to control the FPC 22 and the SPC 24 will be described below.

A part of beam 3 is provided to a connector 26. Alternatively, beams 3- 5 or parts of the other beams 4 and 5 or any other combination of beams 3-5 can be provided to the connector 26. The connector 26 provides beam 3 to a fiber 28. Fiber 28 is part of an interferometer 30 comprising two two-port couplers 32 and 34, a delay loop 36, a second fiber 38 and detectors 40 and 42 to detect the power of the light emitted by fibers 28 and 38. Alternatively, not shown three-port couplers can be used instead of the two-port couplers 32 and 34. Moreover, all kinds of interferometers can be used for the purpose of the present invention, e.g. Michelson-, Mach-Zehnder-, Fabry-Perot-, or Fizeau- interferometers.

A subtractor 44 is connected to the detectors 40 and 42 to subtract the signals detected by the detectors 40 and 42 from each other to provide a resulting signal 46. Resulting signal 46 is provided to a frequency deviation detection unit (FDDU) 48 comprising a memory 50 to store a dependency of the detected frequency detected by detectors 40 and 42 on the tuning velocity of TLS 2. FDDU 48 controls via a high pass filter (HP) 52 with the FPC 22 and via a low pass filter (LP) 54 with the SPC 24.

### An inventive method according to the shown embodiment works as follows:

When tuning the TLS 2 it is generated a laser beam 3 with increasing optical frequency. A part of laser beam 3, e.g. 5 % of beam 3, is coupled to connector 26. Coupler 32 splits the signal of fiber 28 into two parts 56 and 58. These parts 56 and 58 interfere at coupler 34 and generate a signal of a certain frequency, which is an indicator or measure of the tuning rate of the TLS 2. Detector 40 detects a signal having this frequency. Detector 42 detects a signal having the same frequency. These two signals are subtracted by a subtractor 44 to provide signal 46 to the FDDU 48 again having the same but amplitude shifted frequency. FDDU compares the frequency of signal 46 with the frequency stored in memory 50 for the above mentioned tuning velocity of TLS 2. When FDDU 48 detects a deviation of the tuning velocity from the desired above mentioned tuning velocity it provides appropriate control signals to FPC 22 and to SPC 24 to compensate for the deviation until there is no deviation anymore, i.e. the measured tuning velocity is equal to the desired tuning velocity.

According to the above described method it is also possible to compensate jitter on beams 3-5 of TLS 2.

Fig. 2 shows a schematic illustration of a preferred embodiment 48-2 of the FDDU 48. The FDDU 48-2 comprises an electrical signal generator 60 forced by a control unit 62 to generate a desired frequency 66 corresponding to the desired tuning velocity. The desired frequency 66 is phase shifted by a phase shifter 64 to implement a fixed phase relation between the desired frequency 66 and the measured frequency 46 and then desired frequency 66 is compared with the measured frequency 46 measured by the interferometric WRU 30 by mixing the desired frequency 66 and the measured frequency 46 with a mixer 68. A possible detection of a deviation is then be used to influence the TLS 2 according to the above described method.

## Claims

1. A method of manipulating a laser source (2), comprising the steps of:
analyzing an optical signal (3, 4, 5) generated by the laser source (2),
evaluating on the basis of the analysis an actual indicator corresponding with an actual value of a tuning velocity of the laser source (2),
comparing the actual indicator (46) with a desired indicator (66) corresponding with a desired value of the tuning velocity to detect a deviation of the actual value of the tuning velocity from the desired value of the tuning velocity,
compensating the deviation, if any, by manipulating at least one parameter influencing the signal (3, 4, 5) of the laser source (2), wherein said steps comprise
providing a superimposed signal by letting a first part (56) of the signal (3, 4, 5) interfere with a second part (58) of the signal (3, 4, 5), with the first part (56) being delayed with respect to the second part (58), and
evaluating the actual indicator by measuring as the actual indicator a frequency (46) of oscillations of the detected power of the superimposed signal.

2. The method of claim 1, further comprising the steps of:
supplying the desired indicator by using a stored dependency of frequency of oscillations of a detected power of the signal on tuning velocity.

3. The method of claim 1 or claim 2, further comprising the steps of:
supplying the desired indicator (66) by generating as the desired indicator (66) a frequency (66) corresponding to the desired tuning velocity.

4. The method of claim 1 or any one of the above claims, further comprising the steps of:
comparing the actual indicator with a desired indicator (66) by mixing the actual indicator (46) with the desired indicator (66).

5. The method of claim 1 or any one of the above claims, further comprising the steps of:
compensating the deviation if any by manipulating as a parameter a length of a cavity (6) of the laser source (2).

6. The method of claim 5, further comprising the steps of:
compensating a fast deviation, if any, by electro-optically changing an optical path length of the cavity (6); and
compensating a slow deviation if any by mechanically changing an optical path length of the cavity (6).

7. A software program or product, preferably stored on a data carrier, adapted to executing the method of claim 1 or any one of the above claims, when run on a data processing system such as a computer.

8. An apparatus for manipulating a laser source (2), comprising:
an analyzer (30, 48, 48-2) for analyzing an optical signal (3, 4, 5) generated by the laser source (2), and
a compensator (22, 24) connected to the analyzer (30, 48, 48-2) for compensating the deviation if any by manipulating at least one parameter influencing the signal (3, 4, 5) of the laser source (2),
the analyzer (30, 48, 48-2) further comprising an interferometer (30) for letting a first part (56) of the signal (3, 4, 5) interfere with a second part (58) of the signal (3, 4, 5) resulting in a superimposed signal, with the first part (56) being delayed with respect to the second part (58), a detector (40, 42) for detecting the power of the superimposed signal; **characterised in that** the analyzer is adapted for evaluating on the basis of the analysis an actual indicator (46) corresponding with an actual value of a tuning velocity of the laser source (2), and comparing the actual indicator with a desired indicator (66) corresponding with a desired value of the tuning velocity to detect a deviation of the actual value of the tuning velocity from the desired value of the tuning velocity, and a frequency deviation detection unit (48, 48-2) connected to the detector (40, 42) adapted for measuring as the actual indicator a frequency (46) of oscillations of the detected power.

9. The apparatus of daim 8, further comprising:
a memory (50) for storing and supplying a dependency of frequency of oscillations of a detected power of the signal on tuning velocity to supply the desired indicator to the analyzer (30, 48, 48-2),
an electrical signal generator (60) for supplying the desired indicator (66) to the analyzer (30, 48, 48-2) by generating as the desired indicator (66) a frequency corresponding to the desired tuning velocity, and
a mixer (68) for comparing the actual indicator (46) with a desired indicator (66) by mixing the actual indicator (46) with the desired indicator (66).

10. The apparatus of claim 8 or 9, wherein the compensator (22, 24) further comprises:
a manipulator (22, 24) for manipulating as a parameter a length of a cavity (6) of the laser source (2), the manipulator (22,24) being controlled by the analyzer (30, 48, 48-2).

11. The apparatus of claim 10, wherein the manipulator (22, 24) further comprises:
an electro-optical modulator (22) in the path of the beam in the cavity (6) for compensating a fast deviation if any by electro-optically changing an optical path length of the cavity (6).

12. The apparatus of claim 10 or 11, further comprising:
a piezo-electric element (24) acting on an cavity end element (10) of the cavity (6) for compensating a slow deviation if any by mechanically changing an optical path length of the cavity (6).

## Patentansprüche

1. Verfahren zum Einstellen einer Laserquelle (2), wobei das Verfahren die folgenden Schritte umfasst:
Analysieren eines durch die Laserquelle (2) erzeugten optischen Signals (3, 4, 5),
Ermitteln eines aktuellen Indikators ausgehend von der Analyse, wobei der aktuelle Indikator einem aktuellen Wert einer Abstimmgeschwindigkeit der Laserquelle (2) entspricht,
Vergleichen des aktuellen Indikators (46) mit einem gewünschten Indikator (66), der einem gewünschten Wert der Abstimmgeschwindigkeit entspricht, um eine Abweichung des aktuellen Wertes der Abstimmgeschwindigkeit vom gewünschten Wert der Abstimmgeschwindigkeit zu ermitteln,
gegebenenfalls Kompensieren der Abweichung durch Einstellen mindestens eines Parameters zur Beeinflussung des Signals (3, 4, 5) der Laserquelle (2), wobei die Schritte weiterhin folgende Schritte umfassen:
Bereitstellen eines Überlagerungssignals, indem ein erster Teil (56) des Signals (3, 4, 5) zur Interferenz mit einem zweiten Teil (58) des Signals (3, 4, 5) gebracht wird, wobei der erste Teil (56) gegenüber dem zweiten Teil (58) verzögert ist, und
Ermitteln des aktuellen Indikators durch Messen einer Frequenz (46) von Schwankungen der ermittelten Leistung des Überlagerungssignals.

2. Verfahren nach Anspruch 1, das ferner den folgenden Schritt umfasst:
Liefern des gewünschten Indikators anhand einer gespeicherten Abhängigkeit der Schwankungsfrequenz einer ermittelten Leistung des Signals von der Abstimmgeschwindigkeit.

3. Verfahren nach Anspruch 1 oder Anspruch 2, das ferner den folgenden Schritt umfasst:
Liefern des gewünschten Indikators (66) durch Erzeugen einer Frequenz (66), die der gewünschten Abstimmgeschwindigkeit entspricht.

4. Verfahren nach Anspruch 1 oder einem der obigen Ansprüche, das ferner den folgenden Schritt umfasst:
Vergleichen des aktuellen Indikators mit einem gewünschten Indikator (66) durch Mischen des aktuellen Indikators (46) mit dem gewünschten Indikator (66).

5. Verfahren nach Anspruch 1 oder einem der obigen Ansprüche, das ferner den folgenden Schritt umfasst:
Gegebenenfalls Kompensieren der Abweichung durch Einstellen eines Parameters in Form einer Länge eines Resonators (6) der Laserquelle (2).

6. Verfahren nach Anspruch 5, das ferner die folgenden Schritte umfasst:
Gegebenenfalls Kompensieren einer schnellen Abweichung durch elektrooptische Änderung der Länge eines optischen Strahlengangs im Resonator (6); und
Gegebenenfalls Kompensieren einer langsamen Abweichung durch mechanische Änderung der Länge eines optischen Strahlengangs im Resonator (6).

7. Softwareprogramm oder -produkt, das vorzugsweise auf einem Datenträger gespeichert ist und zum Ausführen des Verfahrens nach Anspruch 1 oder einem der obigen Ansprüche geeignet ist, wenn die Software auf einem Datenverarbeitungssystem wie beispielsweise einem Computer läuft.

8. Vorrichtung zum Einstellen eines Laserquelle (2), wobei die Vorrichtung Folgendes umfasst:
einen Analysator (30, 48, 48-2) zum Analysieren eines durch die Laserquelle (2) erzeugten optischen Signals (3, 4, 5), und
einen mit dem Analysator (30, 48, 48-2) verbundenen Kompensator (22, 24) zum Kompensieren der Abweichung, falls eine Abweichung ermittelt wurde, durch Einstellen mindestens eines das Signal (3, 4, 5) der Laserquelle (2) beeinflussenden Parameters,
wobei der Analysator (30, 48, 48-2) ferner Folgendes umfasst: ein Interferometer (30), um einen ersten Teil (56) des Signals (3, 4, 5) zur Interferenz mit einem zweiten Teil (58) des Signals (3, 4, 5) zu bringen und so ein Überlagerungssignal zu erzeugen, wobei der erste Teil (56) gegenüber dem zweiten Teil (58) verzögert ist, und einen Detektor (40, 42) zum Ermitteln der Leistung des Überlagerungssignals,
**dadurch gekennzeichnet, dass** der Analysator so beschaffen ist, dass er anhand der Analyse einen aktuellen Indikator (46) ermittelt, der einem aktuellen Wert einer Abstimmgeschwindigkeit der Laserquelle (2) entspricht, und den aktuellen Indikator mit einem gewünschten Indikator (66) vergleicht, der einem gewünschten Wert der Abstimmgeschwindigkeit entspricht, um eine Abweichung des aktuellen Wertes der Abstimmgeschwindigkeit vom gewünschten Wert der Abstimmgeschwindigkeit zu ermitteln, und
eine mit dem Detektor (40, 42) verbundene Frequenzabweichungserkennungseinheit (48, 48-2), die so beschaffen ist, dass sie den aktuellen Indikator in Form einer Frequenz (46) der Schwankungen der ermittelten Leistung misst.

9. Vorrichtung nach Anspruch 8, die ferner Folgendes umfasst:
einen Speicher (50) zum Speichern und zum Liefern einer Abhängigkeit der Schwankungsfrequenz einer ermittelten Leistung des Signals von der Abstimmgeschwindigkeit, um dem Analysator (30, 48, 48-2) den gewünschten Indikator zur Verfügung zu stellen,
einen elektrischen Signalgenerator (60) zum Liefern des gewünschten Indikators (66) an den Analysator (30, 48, 48-2) durch Erzeugen des gewünschten Indikators (66) in Form einer Frequenz, die der gewünschten Abstimmgeschwindigkeit entspricht, und
eine Mischeinheit (68) zum Vergleichen des aktuellen Indikators (46) mit einem gewünschten Indikator (66) durch Mischen des aktuellen Indikators (46) mit dem gewünschten Indikator (66).

10. Vorrichtung nach Anspruch 8 oder 9, bei welcher der Kompensator (22, 24) ferner Folgendes umfasst:
eine Einstellungseinheit (22, 24) zum Einstellen eines Parameters in Form einer Länge eines Resonators (6) der Laserquelle (2), wobei die Einstellungseinheit durch den Analysator (30, 48, 48-2) gesteuert wird.

11. Vorrichtung nach Anspruch 10, bei welcher die Einstellungseinheit (22, 24) ferner Folgendes umfasst:
einen elektrooptischen Modulator (22) im Strahlengang des Strahls im Resonator (6) zum Kompensieren einer schnellen Abweichung, wenn eine solche Abweichung gefunden wurde, durch elektrooptische Änderung einer optischen Weglänge des Resonators (6).

12. Vorrichtung nach Anspruch 10 oder 11, die ferner Folgendes umfasst:
Ein auf ein Endelement (10) des Resonators (6) einwirkendes piezoelektrisches Element (24) zum Kompensieren eines langsamen Abweichung, wenn eine solche Abweichung gefunden wurde" durch mechanisches Ändern einer optischen Weglänge des Resonators (6).

## Revendications

1. Procédé de manipulation d'une source laser (2), comprenant les étapes suivantes :
analyser un signal optique (3, 4, 5) généré par la source laser (2),
évaluer sur la base de l'analyse un indicateur réel correspondant à une valeur réelle d'une vitesse d'accord de la source laser (2),
comparer l'indicateur réel (46) à un indicateur souhaité (66) correspondant à une valeur souhaitée de la vitesse d'accord pour détecter un écart de la valeur réelle de la vitesse d'accord par rapport à la valeur souhaitée de la vitesse d'accord,
compenser l'écart, éventuel, en manipulant au moins un paramètre influençant le signal (3, 4, 5) de la source laser (2), dans lequel lesdites étapes comprennent:
fournir un signal superposé en amenant une première partie (56) du signal (3, 4, 5) à interférer avec une deuxième partie (58) du signal (3, 4, 5), la première partie (56) étant retardée par rapport à la deuxième partie (58),
évaluer l'indicateur réel, en mesurant comme indicateur réel une fréquence (46) d'oscillation de la puissance détectée du signal superposé.

2. Procédé selon la revendication 1, qui comprend en outre les étapes suivantes :
communiquer l'indicateur souhaité en utilisant une dépendance stockée de la fréquence d'oscillations d'une puissance détectée du signal, vis-à-vis de la vitesse d'accord.

3. Procédé selon la revendication 1 ou la revendication 2, qui comprend en outre les étapes consistant à:
communiquer l'indicateur souhaité (66) en générant comme indicateur souhaité (66) une fréquence (66) correspondant à la vitesse d'accord souhaitée.

4. Procédé selon l'une quelconque des revendications précédentes, qui comprend en outre l'étape suivante :
comparer l'indicateur réel à un indicateur souhaité (66) en mélangeant l'indicateur réel (46) et l'indicateur souhaité (66).

5. Procédé selon l'une quelconque des indications précédentes, qui comprend en outre les étapes consistant à:
compenser l'écart éventuel en manipulant comme paramètre une longueur d'une cavité (6) de la source laser (2).

6. Procédé selon la revendication 5, qui comprend en outre l'étape suivante :
compenser un écart rapide, éventuel, en modifiant électro-optiquement une longueur de trajet optique de la cavité (6); et
compenser un écart lent éventuel en modifiant mécaniquement une longueur de trajet optique de la cavité (6).

7. Programme ou produit logiciel, de préférence stocké sur un porteur de données, apte à exécuter le procédé de l'une quelconque des revendications précédentes, lorsqu'il est mis en oeuvre sur un système de traitement de données comme un ordinateur.

8. Appareil de manipulation d'une source laser (2), comprenant:
un analyseur (30, 48, 48-2) pour analyser un signal optique (3, 4, 5) généré par la source laser (2), et
un compensateur (22, 24) connecté à l'analyseur (30, 48, 48-2) pour compenser l'écart éventuel en manipulant au moins un paramètre influençant le signal (3, 4, 5) de la source laser (2),
l'analyseur (30, 48, 48-2) comprenant en outre un interféromètre (30) pour amener une première partie (56) du signal (3, 4, 5) à interférer avec une deuxième partie (58) du signal (3, 4, 5) en générant un signal superposé, la première partie (56) étant retardée par rapport à la deuxième partie (58), un détecteur (40, 42) de détection de la puissance du signal superposé; **caractérisé en ce que** l'analyseur est apte à évaluer sur la base de l'analyse un indicateur actuel (46) correspondant à une valeur réelle d'une vitesse d'accord de la source laser (2), et à comparer l'indicateur actuel à un indicateur souhaité (66) correspondant à une valeur souhaitée de la vitesse d'accord pour détecter un écart de la valeur réelle de la vitesse d'accord par rapport à une valeur souhaitée de la vitesse d'accord, et une unité de détection (48, 48-2) d'écart de fréquence connectée au détecteur (40, 42) apte à mesurer comme indicateur réel une fréquence (46) d'oscillations de la puissance détectée.

9. Appareil selon la revendication 8, qui comprend en outre:
une mémoire (50) pour stocker et communiquer une dépendance de la fréquence d'oscillations d'une puissance détectée du signal vis-à-vis d'une vitesse d'accord pour communiquer l'indicateur souhaité à l'analyseur (30, 48, 48-2),
un générateur (60) de signal électrique pour communiquer l'indicateur souhaité (66) à l'analyseur (30, 48, 48-2) en générant comme indicateur souhaité (66) une fréquence correspondant à la vitesse d'accord souhaitée, et
un mélangeur (68) pour comparer l'indicateur réel (46) à un indicateur souhaité (66) en mélangeant l'indicateur réel (46) et l'indicateur souhaité (66).

10. Appareil selon la revendication 8 ou 9, dans lequel le compensateur (22, 24) comprend en outre:
un manipulateur (22, 24) pour manipuler comme paramètre une longueur d'une cavité (6) de la source laser (2), le manipulateur (22, 24) étant réglé par l'analyseur (30, 48, 48-2).

11. Appareil selon la revendication 10, dans lequel le manipulateur (22, 24) comprend en outre:
un modulateur électro-optique (22) dans le trajet du faisceau dans la cavité (6) pour compenser un écart rapide éventuel en modifiant électro-optiquement une longueur de trajet optique de la cavité (6).

12. Appareil selon la revendication 10 ou 11, comprenant en outre:
un élément piézoélectrique (24) agissant sur un élément d'extrémité (10) de cavité de la cavité (6) pour compenser un écart lent éventuel en modifiant mécaniquement une longueur de trajet optique de la cavité (6).
